(19) Europäisches Patentamt
European Patent Office
Office européen des brevets

(11) **EP 3 328 164 A1**

(12) **EUROPEAN PATENT APPLICATION**

(43) Date of publication:
**30.05.2018 Bulletin 2018/22**

(51) Int Cl.:
***H05B 37/02*** (2006.01)   *H02M 1/00* (2006.01)

(21) Application number: **17196985.0**

(22) Date of filing: **18.10.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **28.11.2016 GB 201620058**

(71) Applicant: **Tail Wind Engineering Ltd**
**Tetbury, Gloucestershire GL8 8EQ (GB)**

(72) Inventor: **SHEPHARD, Nicholas**
**Tetbury, Gloucestershire GL8 8EQ (GB)**

(74) Representative: **Wynne-Jones, Lainé and James LLP**
**Ground Floor,**
**Capital Building**
**Tyndall Street**
**Cardiff, CF10 4AZ (GB)**

(54) **A SWITCHING SYSTEM FOR AN ELECTRICAL APPLIANCE, A METHOD OF SWITCHING AN ELECTRICAL APPLIANCE AND A LIGHTING ARRANGEMENT INCORPORATING THE SWITCHING SYSTEM**

(57)    A switching system for switching an electrical appliance, a method of switching an electrical appliance and a lighting arrangement is disclosed. The system comprises a control circuit adapted to, in use, receive control input signals and to reconfigure the switching system between a first configuration and a second configuration to cause the electrical appliance to switch between an operative state and standby state, respectively; a power circuit comprising a mains power input, a first power source and a second power source, the first and second power source being configured to drive the control circuit; wherein, in the first configuration the power circuit generates a first current along a first path from the mains power input to the first power source and the electrical appliance, the first current being above a threshold for driving the electrical appliance, and in the second configuration the power circuit generates a second current along a second path from the mains power input, to the second power source and the electrical appliance, the second current being below the threshold for driving the electrical appliance.

Figure 1

## Description

The invention pertains generally to electrical switches. More specifically, the invention relates to a switching system associated with mains power, a method of switching an electrical appliance and to a lighting arrangement comprising such switching system. The switching system uses a unique method of obtaining control power.

Switches in homes and offices are used daily, for example in connection with lights. The most common types of switches are mechanical and prone to trapping dirt owing to frequent use. Touch operated switches and dimmer switches are currently commercially available, however, these are generally limited to a single lighting circuit. This switching system provides a changeover function thereby allowing a single lighting circuit to be controlled from more than one location, for example hall lights.

It is an object of the present invention to provide a technical solution to at least some of the issues outlined above. In particular, to provide a switching system allowing for a direct replacement of existing mains light switches without the need for an additional neutral wire, and having the ability to work with loads ranging from low power energy saving lamps up to the switch rating. Additionally, the switching system is activated by proximity or finger touch operation whilst wearing gloves, or the back of the hand to name but a few activation methods. The invention provides for a design that can be completely encapsulated to maximise electrical insulation and water resistance. The touch surface may be designed to be easy cleaning, painted, or even modified. Metal or metallised plates can be used but with some design considerations to allow the sensor to function effectively.

In accordance with a first aspect of the present invention, there is provided a switching system for switching an electrical appliance, the system comprising a control circuit adapted to, in use, receive control input signals and to reconfigure the switching system between a first configuration and a second configuration to cause the electrical appliance to switch between an operative state and standby state, respectively; a power circuit comprising a mains power input, a first power source and a second power source, the first and second power source being configured to drive the control circuit; wherein, in the first configuration the power circuit generates a first current along a first path from the mains power input to the first power source and the electrical appliance, the first current being above a threshold for driving the electrical appliance, and in the second configuration the power circuit generates a second current along a second path from the mains power input, to the second power source and the electrical appliance, the second current being below the threshold for driving the electrical appliance.

In an embodiment, the first power source comprises a power reservoir configured to be charged by the first power source. The first power source comprises a transforming circuit, the transforming circuit is connected between a power supply input of the switching system and the control circuit, the transforming circuit being actuated by the first current and being configured to charge the power reservoir. The transforming circuit comprises a transformer and an anti-parallel arrangement configured to limit current flowing through a winding of the transformer. The anti-parallel arrangement comprises two diodes connected in parallel to the winding of the transformer, the diodes being configured so that one diode allows a flow of current in a direction which is opposite to a direction of a flow of current allowed by the other diode.

In an embodiment, the control circuit is arranged to generate process control signals in response to the user input signals and the power circuit comprises a relay circuit configured to receive the process control signals from the control circuit, wherein the relay, in the first configuration directs the first current via the first path and in the second configuration, directs the second current via the second path. The relay circuit comprises a first changeover driver connected to a first changeover driver output of the control circuit, the first changeover driver being adapted to reconfigure the switching system to the first configuration, and a second changeover driver connected to a second changeover driver output of the control circuit, the second changeover driver being adapted to reconfigure the switching system to the second configuration. The drivers are operated by the process control signals to selectively allow a relay driving current to flow from the power reservoir via the relay.

In an embodiment, the power circuit comprises a voltage limiting arrangement, such as a Zener diode, electrically connected with the second path and configured to limit the voltage developed across the second power source.

In an embodiment, the power circuit comprises a regulating arrangement, such as a voltage regulator, electrically connected with the second path and configured to regulate the power supplying the control circuit.

In an embodiment, the control circuit comprises a touch sensor adapted to receive the control input signals. The control circuit is configured to monitor the voltage of the power reservoir so that if the voltage of the power reservoir falls below a threshold, the control circuit prohibits the reconfiguration of the switching system. The control circuit is further configured to ensure a minimum time between changes between the first and second configuration. The control circuit is also configured to enter into a sleep state wherein the energy consumed by the control circuit is minimised.

In an embodiment, the second power source comprises a resistor and a capacitor connected in parallel. The second power source also comprises a discharging arrangement configured to discharge the capacitor when the switching system is disconnected from the electric appliance.

In an embodiment, the switching system comprises a further control circuit, connected to the first power source so that the first power source drives the further control circuit, the further control circuit being adapted to reconfigure the system between the first configuration and second configuration.

In accordance with a second aspect of the present invention, there is provided a lighting arrangement for providing illumination, the lighting arrangement comprises at least one light source; a switching system according to any preceding claim, wherein the system is connected to the light source for reconfiguring the light source between an operative state and standby state.

In accordance with a third aspect of the present invention, there is provided a method of switching an electrical appliance, the method comprising the steps of: receiving control input signals at a control circuit; reconfiguring, using the control circuit, a switching system between a first configuration and a second configuration to cause an electrical appliance to switch between an operative state and standby state, respectively; in the first configuration, generating a first current along a first path from a mains power input of a power circuit to a first power source and the electrical appliance, the first current being above a threshold for driving the electrical appliance; in the second configuration, generating, by the power circuit, a second current along a second path from the mains power input of the power circuit, to a second power source and the electrical appliance, the second current being below the threshold for driving the electrical appliance.

Whilst the invention has been described above, it extends to any inventive combination of features set out above or in the following description. Although illustrative embodiments of the invention are described in detail herein with reference to the accompanying drawings, it is to be understood that the invention is not limited to these precise embodiments.

Furthermore, it is contemplated that a particular feature described either individually or as part of an embodiment can be combined with other individually described features, or parts of other embodiments, even if the other features and embodiments make no mention of the particular feature. Thus, the invention extends to such specific combinations not already described.

The invention may be performed in various ways, and, by way of example only, embodiments thereof will now be described with reference to the accompanying drawings, in which:

Figure 1 shows the circuit diagram for the switching system according to an embodiment of the present invention;

Figure 2 shows a schematic of the operational modes of a typical two switch changeover circuit;

Figure 3 shows a typical circular sensor conductor area;

Figure 4 shows the switch plate, sensor, and the light emitting diode.

In the switching system of the present invention, the power supply for the control circuit scavenges indirectly from the load. When the switch is off, a very small current is allowed to flow via the load and power scavenge circuit, which in turn provides a power source for use by the control circuit. When the switch is on, current flows via a transforming circuit, such as a transformer, the switch contacts and the load and the transformer provides a power source for use by one or more control circuits.

Other features of this version include a subtle audible click on switching, automatic calibration to account for customisation, for example stickers or paint. Additional control functions other than on/off that could be incorporated include: time delays, dimmers and wireless interfaces.

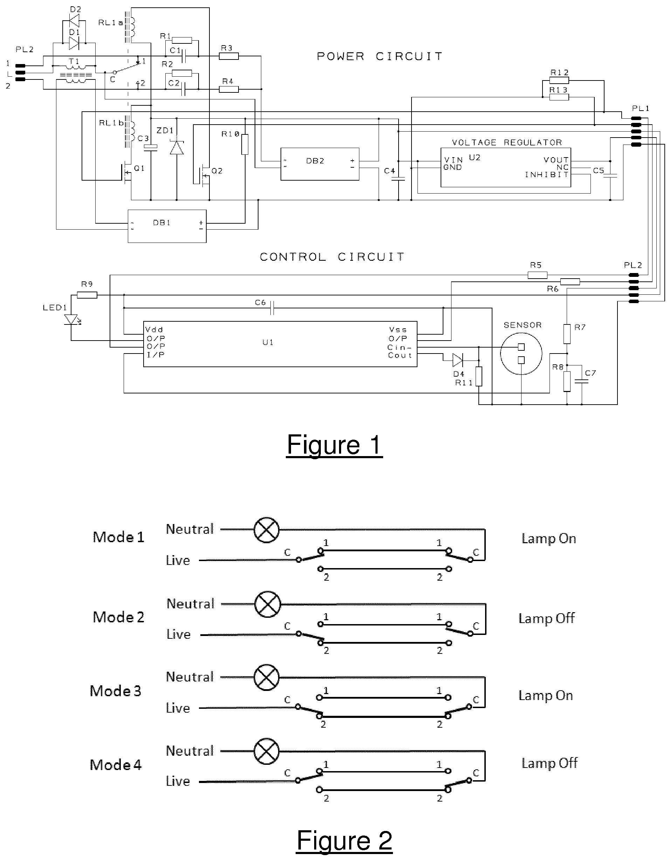

Referring to figure 1, when the switching system is in the off mode, as shown, a second, trickle current flows from the live mains circuit via connector PL2 pin L, through transformer T1 to diode bridge DB2 pin ~, and then via the load connected to DC side of diode bridge DB2 pin + and pin -. The same current also flows via resistor R4, capacitor C2, connector PL2 pin 2, the external electrical appliance such as a light source in the form of a lamp load and to the neutral that the lamp that will nominally be connected. The DC load consists of Zener diode ZD1, and the voltage regulator U2 and its load, C3 and C4 are for energy storage and decoupling. The discharging arrangement comprises resistors R1 and R2 which are bleeder resistors that ensure discharge of the capacitors when the switching system is disconnected from the circuit. The second current flowing in the circuit is set by the supply voltage, capacitor C2 impedance, resistor R4, capacitor C1 and resistor R3 the load on the output of the diode bridge DB2. The load on the output consists of the Zener diode ZD1, capacitor C1, voltage regulator U2, and micro controller U1. The second current causes a voltage to be developed across capacitor C1 with Zener diode ZD1 limiting the voltage and dissipating excess power. The second current flowing in this circuit is limited by design to be insufficient to drive the transformer T1 or the load. Diodes D1 and D2 will only conduct when the current is significantly higher than this trickle current. This current source could be implemented using solid state current regulators, however, for simplicity passive electronic components are used in this design variant.

The Zener diode ZD1 and the diode bridge DB2 forward bias voltage drop limits the ac voltage at the input of DB2, such that in this design, the voltage is approximately 9 Vac, which results in the current that is diverted away from the diode bridge DB2 by capacitor C1 and resistor R3 is approximately 4% of the total current, assuming a 220Vac mains supply. If the load was connected to PL2 pin 1, then the roles of capacitor C1 and resistor R3 will be reversed with capacitor C2 and resistor R4. The function of capacitor C1 and resistor R3 are to ensure power scavenging when the switching system is connected in a changeover circuit if the load is connected to pin 2 of connector PL2, thus enabling the switching systems to operate in a lighting changeover configuration as the load can be connected to either connector PL2 pin 1 or connector PL2 pin 2. Figure 2 shows the four possible switch position modes of operation for a typical lighting circuit with two switches, and when the lamp is off in modes 2 and 4, and the load is connected to either pin 1 or pin 2 of the relay circuit. Referring to figure 1, this corresponds to relay circuit RL1 pin 1 and pin 2, thus explaining the purpose of capacitor C1, resistor R3 and capacitor C2 and resistor R4. In an alternative embodiment, the relay circuit may include a solid-state relay having no moving elements. When the switching system is in the on mode, current flows from the connector PL2 L pin through transformer T1, relay RL1 (pin C to 2), the connected load and then to the neutral return. The voltage produced at secondary winding of transformer T1 is rectified by diode bridge DB1, which then charges the power supply reservoir capacitor C3 via resistor R10, up to the voltage limited by Zener diode ZD1. The circuits described during the off mode do not provide power to the reservoir capacitor C3 when relay RL1 pin C is connected to pin 2.

The power supply reservoir capacitor C3 is sized to accommodate driving the relay coil RL1 a or relay coil RL1b with a pulse and also power the voltage regulator U2. A low drop out voltage regulator U2 in conjunction with C4 and C5 are used to provide a regulated voltage supply for the control circuit. The voltage across the power supply reservoir capacitor C3 is routed to the control circuit via potential divider formed by resistor R7 and resistor R8. Capacitor C7 provides signal filtering before being routed to the I/P pin of the controller U1. If the voltage of the reservoir capacitor C3 is below a predetermined level commensurate with sufficient charge to provide a pulse without affecting the voltage regulator operation, then relay control pulses will be prohibited. A secondary limitation is also employed in the controller so that there will always be a minimum time between relay control pulses. The quiescent power for the controller circuit is of the order of a few milliwatts, however, this may be reduced further by introducing sleep periods for the controller.

Transformer T1 design is specifically designed so that when the switching system is carrying the minimum load current, for example when controlling a low energy lamp, the voltage developed across the primary winding is just marginally less that the voltage limited by the anti-parallel arrangement, such as diodes D1 and D2. If the switching system current exceeds the minimum load current, then diodes D1 and D2 start to conduct and additional current will be diverted away from the transformer winding, thus allowing the transformer to have a primary current rating significantly lower than that of the switching system which allows for small physical size of the transformer. The transformer secondary voltage is simply the primary voltage multiplied by the windings turns ratio, however, the transformer winding resistances must also be taken into account in achieving an adequate DC supply voltage. Assuming a typically diode with forward voltage of 0.7V and assuming a minimum design current of 20 mA, for example a 5 W lamp at 240V, the power available to the transformer primary would typically be 14 mVA. The transformer must be designed so that at the minimum design current, the primary impedance maintains the voltage below the diode conduction region, thus required primary winding inductance can simplistically be defined by the following equations:

$$\text{Impedance } X_L = 2\pi f L$$

where f is frequency and L is the inductance

Assuming a sinusoidal voltage waveform, Vfwd is the diode forward voltage drop and Rp is the primary winding resistance, then

$$\text{Impedance } X_L = Lp * \frac{Vfwd}{\sqrt{2}} + Rp$$

and

$$Lp = \sqrt{2} * X_L / Vfwd$$

Additionally adequate magnetising current must be ensured and the secondary winding voltage Vs = Vp*Ns/Np, however, losses due to winding resistances should be factored into calculating Ns. Vs is the secondary voltage, Vp is the primary voltage, Ns is the number of secondary winding turns and Np is the number of primary winding turns.

The control circuit could be implemented in several different ways which would offer the flexibility of incorporating many other functional features. This version is based around a microcontroller with an integrated comparator, as it meets the needs of this application. This version shows one output for a light emitting diode (LED), two output signals to drive relay RL1, one input signal that is used to monitor the reservoir voltage, one input signal comparator inverting input (Cin-), and one output signal comparator output (Cout).

A relaxation oscillator is used to generate a sensor excitation frequency determined by the capacitance of the sensor, sensor discharge resistor R11 and the comparator reference voltage. The comparator reference voltage is selected internally by the microcontroller, enabling automatic calibration.

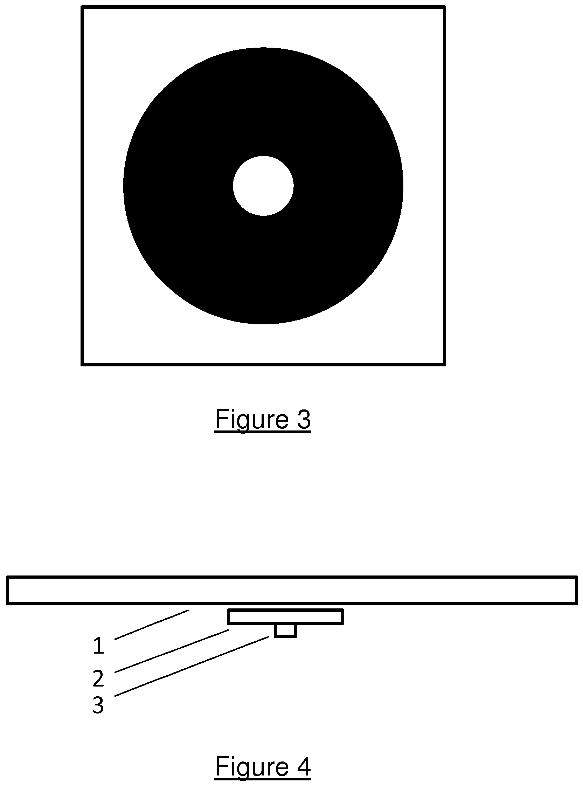

The sensor in this case is a circular electrically conductive area, with a hole to allow for an LED indicator as shown in Figure 3. An electrical guard ring may be employed around the sensor to modify the sensing area.

Figure 4, shows the switching system plate (1), sensor (2), and the LED (3). The sensing area typically forms a capacitance between the sensing plate and the ground reference of the circuit. The insulating plate (1) and air gaps forming the dielectric for this capacitor, and this can be effectively increased by changes to the electric field by an approaching object.

When the dielectric between the sensing plate and ground increases with proximity to the switching system, then the capacitance increases resulting in a decrease in oscillator frequency, thereby allowing detection of a touch input. The detected change is then conditioned and processed to control the changeover of a bi-stable relay by driving either first changeover driver, such as transistor Q1 or second changeover driver, such as transistor Q2 accordingly with a short duration pulse to enable contact changeover. It will be apparent to a person skilled in the art that the transistors may be replaced by other switching components.

Functional features included in this controller variant are automatic calibration, default switching system position on power up, reservoir voltage management. Other functional features may include time delays on/off, selectable modes, dimmer control, solid state switches and interfaces with wireless communications.

From the foregoing therefore, it is evident that the switching system and the method of switching provide an improved means of switching an electrical appliance without the need for an additional neutral wire.

**Claims**

1. A switching system for switching an electrical appliance, the system comprising:

   a control circuit adapted to, in use, receive control input signals and to reconfigure the switching system between a first configuration and a second configuration to cause the electrical appliance to switch between an operative state and standby state, respectively;
   a power circuit comprising a mains power input, a first power source and a second power source, the first and second power source being configured to drive the control circuit;
   wherein,
   in the first configuration the power circuit generates a first current along a first path from the mains power input to the first power source and the electrical appliance, the first current being above a threshold for driving the electrical appliance, and in the second configuration the power circuit generates a second current along a second path from the mains power input, to the second power source and the electrical appliance, the second current being below the threshold for driving the electrical appliance.

2. A switching system according to claim 1, wherein the first power source comprises a power reservoir capacitor configured to be charged by the first power source.

3. A switching system according to claim 2, wherein the first power source comprises a transforming circuit, the transforming circuit is connected between a power supply input of the switching system and the control circuit, the transforming circuit being actuated by the first current and being configured to charge the power reservoir capacitor.

4. A switching system according to claim 3, wherein the transforming circuit comprises a transformer and an anti-parallel arrangement configured to limit current flowing through a winding of the transformer.

5. A switching system according to claim 4, wherein the anti-parallel arrangement comprises two diodes connected in parallel to the winding of the transformer, the diodes being configured so that one diode allows a flow of current in a direction which is opposite to a direction of a flow of current allowed by the other diode.

6. A switching system according to any preceding claim, wherein the control circuit is arranged to generate process control signals in response to the user input signals and the power circuit comprises a relay circuit configured to receive the process control signals from the control circuit, wherein the relay, in the first configuration directs the first current via the first path and in the second configuration, directs the second current via the second path.

7. A switching system according to claim 6, wherein the relay circuit comprises a first changeover driver connected to a first changeover driver output of the control circuit, the first changeover driver being adapted to reconfigure the switching system to the first configuration, and a second changeover driver connected to a second changeover driver output of the control circuit, the second changeover driver being adapted to reconfigure the switching system to the second configuration.

8. A switching system according to claim 7 when appended to claim 2, wherein the drivers are operated by the process control signals to selectively allow a relay driving current to flow from the power reservoir via the relay.

9. A switching system according to any preceding claim, wherein the power circuit comprises a voltage limiting arrangement electrically connected with the second path and configured to limit the voltage developed across the second power source.

10. A switching system according to any preceding claim, wherein the power circuit comprises a regulating arrangement electrically connected with the second path and configured to regulate the power supplying the control circuit.

11. A switching system according to claims 2, wherein the control circuit is configured to monitor the voltage of the power reservoir so that if the voltage of the power reservoir capacitor falls below a threshold, the control circuit prohibits the reconfiguration of the switching system.

12. A switching system according to any preceding claim, wherein the second power source comprises a resistor and a capacitor connected in parallel, the second power source comprising a discharging arrangement configured to discharge the capacitor when the switching system is disconnected from the electric appliance.

13. A switching system according to any preceding claim, the system comprising a further control circuit, connected to the first power source so that the first power source drives the further control circuit, the further control circuit being adapted to reconfigure the system between the first configuration and second configuration.

14. A lighting arrangement for providing illumination, the lighting arrangement comprises:

    at least one light source;
    a switching system according to any preceding claim, wherein the system is electrically connected to the light source for reconfiguring the light source between an operative state and standby state.

15. A method of switching an electrical appliance, the method comprising the steps of:

    receiving control input signals at a control circuit;
    reconfiguring a switching system between a first configuration and a second configuration using the control circuit to cause an electrical appliance to switch between an operative state and standby state, respectively;
    in the first configuration, generating a first current along a first path from a mains power input of a power circuit to a first power source and the electrical appliance, the first current being above a threshold for driving the electrical appliance;
    in the second configuration, generating a second current along a second path from the mains power input of the power circuit, to a second power source and the electrical appliance, the second current being below the threshold for driving the electrical appliance.

## Figure 1

## Figure 2

Figure 3

1
2
3

Figure 4

Europäisches
Patentamt

European
Patent Office

Office européen
des brevets

# EUROPEAN SEARCH REPORT

Application Number

EP 17 19 6985

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/025802 A1 (CARMEN DANIEL F [US]) 2 February 2012 (2012-02-02) | 1-3,6-15 | INV. H05B37/02 |
| A | * paragraphs [0026] - [0055], [0060]; figures 1-6 * | 4,5 | ADD. H02M1/00 |

TECHNICAL FIELDS
SEARCHED      (IPC)

H05B
H02M

The present search report has been drawn up for all claims

| Place of search | Date of completion of the search | Examiner |
|---|---|---|
| Munich | 9 April 2018 | Waters, Duncan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 19 6985

This annex lists the patent family members relating to the patent documents cited in the above-mentioned European search report.
The members are as contained in the European Patent Office EDP file on
The European Patent Office is in no way liable for these particulars which are merely given for the purpose of information.

09-04-2018

| Patent document cited in search report | Publication date | Patent family member(s) | Publication date |
|---|---|---|---|
| US 2012025802 A1 | 02-02-2012 | CA 2806248 A1<br>CN 103155392 A<br>EP 2599208 A1<br>US 2012025802 A1<br>WO 2012016119 A1 | 02-02-2012<br>12-06-2013<br>05-06-2013<br>02-02-2012<br>02-02-2012 |

EPO FORM P0459

For more details about this annex : see Official Journal of the European Patent Office, No. 12/82